# EUROPEAN PATENT APPLICATION

(11) **EP 3 263 670 A1**
(43) Date of publication of application: **03.01.2018**
(21) Application number: 16754931.0
(22) Date of filing: 12.02.2016
(51) Int. Cl.: C09K 3/14, B24B 37/00, C09G 1/02, H01L 21/304

(54) **COMPOSITION FOR POLISHING, POLISHING METHOD AND METHOD FOR PRODUCING HARD-BRITTLE MATERIAL SUBSTRATE**

(30) Priority: 23.02.2015 JP 2015033278
(71) Applicant: Fujimi Incorporated, Kiyosu-shi, Aichi 452-8502 (JP)
(72) Inventor: SERIKAWA, Masayuki, Kiyosu-shi Aichi 452-8502 (JP); TENKOU, Kyousuke, Kiyosu-shi Aichi 452-8502 (JP); AKIYAMA, Tomomi, Kiyosu-shi Aichi 452-8502 (JP); ASAI, Maiko, Kiyosu-shi Aichi 452-8502 (JP)
(74) Representative: Grünecker Patent- und Rechtsanwälte PartG mbB
(86) International application number: PCT/JP2016/000748
(87) International publication number: WO 2016/136177

(57) **Abstract**

There is provided a polishing composition for use in polishing of a surface of a polishing object including at least one of an oxide of a metal or a semimetal or a composite material of oxides of one or more metals and/or semimetals, and the polishing composition includes at least water and silica. The silica includes small-particle diameter silica having a particle diameter of 20 nm or more to 70 nm or less and large-particle diameter silica having a particle diameter of 100 nm or more to 200 nm or less, 2 mass% or more of the small-particle diameter silica is included in the polishing composition, 2 mass% or more of the large-particle diameter silica is included in the polishing composition, and a value obtained by dividing an average particle diameter of the large-particle diameter silica by an average particle diameter of the small-particle diameter silica is 2 or more.

## Description

### Technical Field

The present invention relates to a polishing composition for use in polishing of a polishing object including an oxide of a metal or a semimetal, or a composite material of oxides of one or more metals and/or semimetals, a polishing method, and a method for manufacturing a hard brittle substrate.

### Background Art

A ceramic product including an oxide of a metal or a semimetal, or a composite material of oxides of one or more metals and/or semimetals is widely used as various types of electronic devices, functional ceramic, or a hard material, for example.

To polish the surface of such a ceramic product of a hard brittle material for mirror finishing or smoothing, a polishing composition including diamond abrasives has been typically used as disclosed in PTLs 1 and 2. The polishing composition including diamond abrasives, however, is expensive and susceptible to scratches, and thus, has difficulty in obtaining a high-grade mirror surface.

PTLs 3 and 4 propose the use of a polishing composition using colloidal silica as abrasives. A polishing composition using colloidal silica as abrasives, however, did not obtain a sufficient polishing rate.

### Citation List

### Patent Literatures

PTL 1: JP H07-179848 A
PTL 2: JP 2008-290183 A
PTL 3: JP 2008-44078 A
PTL 4: WO 2003-529662

### Summary of Invention

### Technical Problem

An object of the present invention is to provide, at low costs, a polishing composition that can reduce occurrence of defects such as scratches to achieve a high polishing rate in polishing ceramic including, for example, oxide crystal to be used for an electronic device or the like that requires a highly accurate smooth surface or a high texture obtained by mirror finishing.

### Solution to Problem

A polishing composition according to an aspect of the present invention is used for polishing of a surface of a polishing object including at least one of an oxide of a metal or a semimetal or a composite material of oxides of one or more metals and/or semimetals, and includes at least water and silica. The silica includes small-particle diameter silica having a particle diameter of 20 nm or more to 70 nm or less and large-particle diameter silica having a particle diameter of 100 nm or more to 200 nm or less, 2 mass% or more of the small-particle diameter silica is included in the polishing composition, 2 mass% or more of the large-particle diameter silica is included in the polishing composition, and a value obtained by dividing an average particle diameter of the large-particle diameter silica by an average particle diameter of the small-particle diameter silica is 2 or more.

In a polishing composition according to another aspect of the present invention, a proportion of a sum of the small-particle diameter silica and the large-particle diameter silica in a total amount of the silica may be 90 mass% or more.

In a polishing composition according to another aspect of the present invention, 50 mass% or more of the small-particle diameter silica may be included in the total amount of the silica.

In a polishing composition according to another aspect of the present invention, a content of each of the small-particle diameter silica and the large-particle diameter silica may be 4 mass% or more.

In a polishing composition according to another aspect of the present invention, the polishing composition may have a pH of 7.5 or more to 9.8 or less.

A polishing method according to an aspect of the present invention is a polishing method for polishing a surface of a polishing object including an oxide of a metal or a semimetal selected from Groups 3, 4, and 13 or a composite material of oxides of one or more metals and/or semimetals selected from Groups 3, 4, and 13, by using the polishing composition according to the above aspect.

A polishing method according to an aspect of the present invention is a polishing method for polishing a hard brittle substrate by using the polishing composition according to the above aspect.

A method for manufacturing a hard brittle substrate according to another aspect of the present invention includes the step of polishing a hard brittle substrate by using the polishing method according to the above aspect.

### Advantageous Effects of Invention

The polishing composition according to the present invention can obtain a high polishing rate in polishing a polishing object of, for example, an oxide of a metal or a semimetal.

### Brief Description of Drawings

An embodiment of the present invention will now be described.

In an embodiment of the present invention, a polishing object is an oxide of a metal or a semimetal, or a composite of the oxides of the metal and the semimetal. In particular, one or more oxides of one or more metals or semimetals selected from Groups 3, 4, and 13 of the periodic table or a composite material of oxides of one or more metals and/or semimetals selected from Groups 3, 4, and 13 is preferable. The composite material herein refers to a composite material obtained from the oxides described above, a mixed material of composite oxides, or another material. The oxides may be a single crystal, a polycrystal, or a sintered body (ceramic) . For example, a Group 3 metal in the periodic table can be Y, a Group 4 metal can be Ti or Zr, a Group 13 metal can be Al, Ga, or In, but the present invention is not limited to these metals. Examples of the oxides include aluminium oxide (alumina), titanium oxide (titania), zirconium oxide (zirconia), gallium oxide, yttrium oxide (yttria), germanium oxide, and composite oxides thereof. Among them, more effective polishing objects are aluminium oxide (e.g., corundum), zirconium oxide, and yttrium oxide. The oxide crystals, a composite material thereof, or a sintered body thereof is a hard brittle material and is used for an electronic device or the like, and thus, is often required of a highly accurate polishing process.

### (Abrasives)

Silica in the polishing composition according to an embodiment of the present invention includes small-particle diameter silica having a particle diameter of 20 nm or more to 70 nm or less and large-particle diameter silica having a particle diameter of 100 nm or more to 200 nm or less. In this specification, for convenience, small silica having a particle diameter of 20 nm or more to 70 nm or less will be referred to as small-particle diameter silica, and silica having a particle diameter of 100 nm or more to 200 nm or less will be hereinafter referred to as large-particle diameter silica. The particle diameter, larger diameter, and shorter diameter of silica are measured with, for example, image analysis software from a scanning electron microscope image of silica. The particle diameter of silica can be obtained as a diameter of a circle having the same area as an area of particles of silica in a scanning electron microscopic image. An average particle diameter of silica is an average value of particle diameter s of particles in a visual field of a scanning electron microscope. The longer diameter and the shorter diameter of each particle can be obtained as a longer side and a shorter side, respectively, of a minimum circumscribed rectangle in a scanning electron microscopic image of the particle. An aspect ratio of silica is a value obtained by dividing the value of the longer diameter of each particle by the value of the shorter diameter thereof, and is an average value of aspect ratios of particles in a visual field of the scanning electron microscope.

Among silica included in the polishing composition, the content of each of the small-particle diameter silica having a particle diameter of 20 nm or more to 70 nm or less and the large-particle diameter silica having a particle diameter of 100 nm or more to 200 nm or less is 2 mass% or more of the polishing composition. The content can be obtained by calculating the proportion of the small-particle diameter silica or the large-particle diameter silica in silica included in the polishing composition and multiplying the content of the entire silica in the polishing composition by the obtained proportion. Preferably, the polishing composition includes 4 mass% or more of each of the small-particle diameter silica and the large-particle diameter silica.

Among silica included in the polishing composition, suppose the average particle diameter of the small-particle diameter silica is A and the average particle diameter of the large-particle diameter silica is B, the value obtained by dividing B by A, that is, the value of B/A, is preferably 2 or more, more preferably 2.5 or more, and much more preferably 3 or more. As the value of B/A increases, the achieved polishing rate increases.

The proportion of the sum of the small-particle diameter silica and the large-particle diameter silica in the entire silica included in the polishing composition is preferably 90 mass% or more and more preferably 95 mass% or more.

The proportion of the small-particle diameter silica in the entire silica included in the polishing composition is preferably 50 mass% or more and more preferably 60 mass% or more. As long as the proportion of the small-particle diameter silica is within the above ranges, the number of points of application of silica in contact with the polishing object surface increases so that a higher polishing rate can be obtained without an increase in the total silica amount.

The upper limit of the content of silica in the polishing composition is not limited to a specific value, and is preferably 50 mass% or less and more preferably 40 mass% or less. As the content of silica decreases, dispersion stability of the polishing composition is enhanced, and thus, the polishing composition can be more easily processed. According to the present invention, a high polishing rate can be obtained with a low content of silica, and a high polishing rate can be maintained for a long period in circulation use. Accordingly, a polishing step can be performed at low costs.

An aspect ratio (larger diameter/shorter diameter) of the large-particle diameter silica included in the polishing composition is preferably 1.1 or less. As the difference between the larger diameter and the smaller diameter decreases so that large-particle diameter silica approaches a sphere, silica more easily rotates at a polishing interface. Thus, silica serves as rollers between a polishing object and a polishing pad to, thereby, reduce a polishing resistance.

Silica is not limited to a specific type, and examples of silica include colloidal silica, fumed silica, and sol-gel-derived silica. These silicas may be used singly or in combination of two or more of them. Among them, fumed silica and colloidal silica are preferable from the viewpoint of more efficiently smoothing the surface of ceramic.

The polishing composition may include abrasives except silica. Examples of the abrasives except silica include alumina, zirconia, ceria, and titania. The proportion of the abrasives except silica in the polishing composition is preferably as small as possible. Substantially no abrasives except silica are preferably included in the polishing composition.

### (pH and pH Adjuster)

The polishing composition has a pH of preferably 7.5 or more and more preferably 7 . 8 or more. The pH of the polishing composition is preferably 9 . 8 or less and more preferably 9. 5 or less. As long as the pH is within the above ranges, a polishing rate and dispersion stability of abrasives can be enhanced. In addition, the polishing composition can be treated with safety. When the pH is within the above ranges, the polishing rate is at maximum. The reason for the maximum polishing rate obtained in the pH ranges described above is supposed to be related to a zeta potential of ceramic constituting a polishing object.

The pH of the polishing composition according to the present invention can be adjusted with a pH adjuster. The pH adjuster is used for adjusting the pH of the polishing composition, thereby controlling a polishing rate of ceramic and dispersibility of abrasives, for example. The pH adjuster can be used singly or in combination of two or more of types.

As the pH adjuster, a known acid, a known base, or a salt thereof can be used. Specific examples of the acid that can be used as the pH adjuster include inorganic acids such as hydrochloric acid, sulfuric acid, nitric acid, hydrogen fluoride, boric acid, carbonic acid, hypophosphorous acid, phosphorous acid, and phosphoric acid, and organic acids such as formic acid, acetic acid, propionic acid, butyric acid, valeric acid, 2-methyl butyric acid, n-hexanoic acid, 3,3-dimethyl butyric acid, 2-ethyl butyric acid, 4-methyl pentanoic acid, n-heptanoic acid, 2-methyl hexanoic acid, n-octanoic acid, 2-ethyl hexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, diglycolic acid, 2-furan carboxylic acid, 2,5-furan dicarboxylic acid, 3-furan carboxylic acid, 2-tetrahydrofuroic acid, methoxy acetic acid, methoxy phenyl acetic acid, and phenoxy acetic acid. In the case of using an inorganic acid as the pH adjuster, sulfuric acid, nitric acid, hydrochloric acid, and phosphoric acid, for example, are especially preferable from the viewpoint of enhancement of a polishing rate. In the case of using an organic acid as the pH adjuster, glycolic acid, succinic acid, maleic acid, citric acid, tartaric acid, malic acid, gluconic acid, and itaconic acid are preferable.

Examples of the base that can be used as the pH adjuster include amines such as aliphatic amine and aromatic amine, organic bases such as quaternary ammonium hydroxide, hydroxides of alkali metals such as potassium hydroxide, hydroxides of alkaline earth metals, and ammonia.

Among them, potassium hydroxide and ammonia are preferable in terms of availability.

Instead of the acids or in combination with the acids, an ammonium salt of the acid or a salt such as alkali metal salt may be used as the pH adjuster. In particular, in the case of using salts of combinations of weak acids and strong bases, strong acids and weak bases, or weak acids and weak bases, a buffer function of pH is expected. The case of using a combination of strong acid and strong base, not only pH but also electric conductivity can be adjusted with a small amount of the pH adjuster.

The amount of addition of the pH adjuster is not limited to a specific amount, and may be adjusted as necessary so that the polishing composition has a desired pH.

Another embodiment of the present invention is directed to a method for polishing a hard brittle substrate with which a hard brittle substrate is polished by using a polishing composition. Yet another embodiment is directed to a method for manufacturing a hard brittle substrate including the step of polishing a hard brittle substrate by using the polishing method of the above embodiment.

With the polishing composition according to the embodiment of the present invention, a polishing object of, for example, an oxide crystal of a metal or a semimetal can be polished at a high polishing rate. Although it is not intended to restrict by theory, a mechanism of this polishing function can be as follows. Specifically, in a case where silica having a particle diameter of 100 nm or more to 200 nm or less and silica having a particle diameter of 20 nm or more to 70 nm or less have an appropriate average particle diameter and appropriate amounts of such silicas are included in a polishing composition, these silicas are supposed to synergistically enhance their mechanical polishing functions and provide remarkably high polishing rates. In this case, main silica in the entire silica included in the polishing composition is preferably large-particle diameter silica having a particle diameter of 100 nm or more to 200 nm or less and providing a large mechanical polishing function. On the other hand, a solid phase reaction between the abrasive surface and the polishing object of oxide crystal is supposed to contribute to enhancement of a polishing rate. Thus, it is supposed that inclusion of silica having a sufficiently large surface area in the polishing composition can sustain polishing performance for a longer period and maintain polishing performance. According to the present invention, appropriate amounts of large-particle diameter silica having a particle diameter of 100 nm or more to 200 nm or less and small-particle diameter silica having a particle diameter of 20 nm or more to 70 nm or less are included in the polishing composition so that a remarkably high polishing rate can be obtained.

### (Water)

The polishing composition according to the present invention includes water as a dispersing agent or a solvent for dispersing or dissolving components . From the viewpoint of suppressing inhibition of functions of other components, water containing impurities as little as possible is preferably used. Specifically, pure water, ultrapure water, or distilled water from which foreign matters are removed through a filter after removal of impurity ions by using an ion-exchange resin is preferably used.

### (Other Components)

The polishing composition according to this embodiment may include additives for enhancing the polishing rate, such as a complexing agent, an etchant, or an oxidizing agent, as necessary in order to enhance performance of the polishing composition. The polishing composition may also include a water-soluble polymer (that may be a copolymer or a salt or a derivative thereof) that acts on the surface of a polishing object or the surface of abrasives. The polishing composition may further include an additive such as a dispersing agent for enhancing dispersibility of abrasives or a dispersion aid for easing redispersion of an agglomerate, as necessary.

The polishing composition may further include known additives such as a preservative, a mildewproofing agent, an anti-corrosive agent, or a rust preventive agent, as necessary.

These additives are known in a large number of patent literatures or other documents as agents that can be generally added to a polishing composition, and are not limited to specific type and amount of addition. In a case where these additives are added to the polishing composition, the amount of the additives is preferably less than 1 mass%, more preferably less than 0.5 mass%, and much more preferably less than 0.1 mass%, of the polishing composition.

Examples of the complexing agent include inorganic acids, organic acids, amino acids, nitrile compounds, and chelating agents. Specific examples of the inorganic acids include sulfuric acid, nitric acid, boric acid, and carbonic acid. Specific examples of the organic acids include formic acid, acetic acid, propionic acid, butyric acid, valeric acid, 2-methyl butyric acid, n-hexanoic acid, 3, 3-dimethyl butyric acid, 2-ethyl butyric acid, 4-methyl pentanoic acid, n-heptanoic acid, 2-methyl hexanoic acid, n-octanoic acid , 2-ethyl hexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid. Organic sulfuric acids such as methanesulfonic acid, ethanesulfonic acid, and isethionic acid may be used. Instead of or in combination with inorganic acids or organic acids, salts such as alkali metal salts of the inorganic acids or organic acids may be used. Among them, glycin, alanine, malic acid, tartaric acid, citric acid, glycolic acid, isethionic acid, and salts thereof are preferable.

Examples of the etchants include inorganic acids such as nitric acid, sulfuric acid, hydrochloric acid, phosphoric acid, and hydrogen fluoride, organic acids such as acetic acid, citric acid, tartaric acid, and methanesulfonic acid, inorganic alkalis such as potassium hydroxide and sodium hydroxide, and organic acids such as ammonia, amine, and quaternary ammonium hydroxide.

Examples of the oxidizing agents include hydrogen peroxide, peracetic acid, percarbonate, urea peroxide, perchlorate, persulfate, and nitric acid.

Examples of the water-soluble polymer, the copolymer, and the salt and derivative thereof include polycarboxylic acid such as polyacrylate, polysulfonic acid such as polyphosphonic acid and polystyrene sulfonic acid, polysaccharides such as xanthan gum and sodium alginate, cellulose derivatives such as hydroxyethyl cellulose and carboxymethyl cellulose, polyethylene glycol, polyvinyl alcohol, polyvinyl pyrrolidone, sorbitan monooleate, and an oxyalkylene polymer having one or more types of oxyalkylene units.

Examples of the dispersion aid include condensed phosphate salts such as pyrophosphate salts and hexametaphosphate salts. Examples of the preservatives include sodium hypochlorite. Examples of the mildewproofing agent include oxazoline such as oxazolidine-2,5-dione.

Examples of the anti-corrosive agents include amines, pyridines, a tetraphenylphosphonium salt, benzotriazoles, triazoles, tetrazoles, and benzoic acid. Examples of the chelating agent include carboxylic acid-based chelating agents such as gluconic acid, amine-based chelating agents such as ethylene diamine, diethylene triamine, and trimethyl tetraamine, polyamino polycarboxylic chelating agents such as ethylenediamine tetraacetic acid, nitrilotriacetic acid, hydroxyethyl ethylenediamine triacetic acid, triethylenetetramine hexaacetic acid, and diethylenetriamine pentaacetic acid, organic phosphonic acid-based chelating agents such as 2-aminoethyl phosphonic acid, 1-hydroxyethylidene-1,1-diphosphonic acid, amino tri(methylene phosphonic acid), ethylene diamine tetrakis(methylene phosphonic acid), diethylenetriamine penta(methylene phosphonic acid), ethane-1,1-diphosphonic acid, ethane-1,1,2-triphosphonic acid, methanehydroxy phosphonic acid, and 1-phosphonobutane-2,3,4-tricarboxylic acid, a phenol derivative, and 1,3-diketone.

### (Method for Producing Polishing Composition)

The method for producing a polishing composition according to this embodiment is not limited to a specific method, and a polishing composition can be produced by stirring and mixing, in a liquid solvent such as water, silica (abrasives) including large-particle diameter silica and small-particle diameter silica having predetermined contents, predetermined average particle diameter s, an average particle diameter ratio (B/A), and a predetermined aspect ratio and additives as necessary. For example, a polishing composition can be produced by stirring and mixing, in water, silica including large-particle diameter silica and small-particle diameter silica and additives such as a pH adjuster. The temperature in mixing is not limited to a specific temperature, and is preferably 10°C or more to 40°C or less. In mixing, heating may be performed in order to increase a dissolution rate, and a mixing time is not limited to a specific time.

The polishing composition may be a one-pack type or a multi-pack type including a two-pack type or more. In the case of using a polishing apparatus including a plurality of supply paths for a polishing agent, two or more compositions may be prepared beforehand so that the compositions are mixed in a polishing apparatus to form a polishing composition.

The polishing composition may be prepared by diluting an undiluted solution of a polishing composition with water. In a case where the polishing composition is a two-pack type, mixing and dilution of compositions may be performed in any order. For example, after one composition is diluted with water, this diluted composition may be mixed with another composition. Alternatively, mixing and dilution with water of these compositions may be performed at the same time, or the compositions may be mixed and then diluted with water.

### (Polishing Apparatus and Polishing Method)

The polishing composition can be used in an apparatus under conditions that are typically used in polishing a polishing object of oxide crystal. As a polishing apparatus, a single-side polishing apparatus or a double-side polishing apparatus can be typically used. The single-side polishing apparatus holds a polishing object with a holder called a carrier, and a surface plate to which a polishing pad is attached is pressed against one side of the polishing object and the surface plate is rotated with a supply of the polishing composition so that the polishing object is polished at one side. The double-side polishing apparatus holds a polishing object with a carrier, and surface plates to each of which a polishing pad is attached are pushed against both sides of the polishing object and the surface plates are rotated in opposite directions with a supply of the polishing composition from above so that the polishing object are polished at both sides. At this time, the polishing object is polished by a physical action by friction between the polishing pad and the polishing composition and the polishing object and a chemical action of the polishing composition on the polishing object.

Polishing conditions include a polishing load. In general, as the polishing load increases, a friction force between abrasives and the polishing object increases. As a result, mechanical processing characteristics are enhanced so that the polishing rate increases. The polishing load applied to the polishing object is not limited to a specific level, and is preferably 50 to 1000 g/cm², more preferably 100 to 800 g/cm², and much more preferably 150 to 600 g/cm². As long as the polishing load is within the above ranges, a sufficiently high polishing rate can be obtained, and in addition, damage of the polishing object and occurrence of surface defects can be reduced.

Polishing conditions include a linear rate. In general, the linear rate is affected by the rotation rate of the polishing pad, the rotation rate of the carrier, the size of the polishing object, and the number of polishing objects, for example. In a case where the linear rate is high, abrasives frequently contact the polishing object, and thus, a significant frictional force is exerted between the polishing object and the abrasives, and a mechanical polishing function on the polishing object increases. Heat generated by friction can enhance a chemical polishing function by the polishing composition in some cases. The linear rate is not limited to a specific rate, and is preferably 10 to 300 m/min and more preferably 30 to 200 m/min. As long as the linear rate is within the above ranges, a sufficiently high polishing rate can be obtained, and in addition, an appropriate friction force can be applied to the polishing object. On the other hand, friction directly occurring between the polishing pad and the polishing object does not contribute to polishing, and thus, is preferably as small as possible.

The polishing pad is not limited to specific properties such as material, thickness, or hardness. For example, any polishing pad may be used, specifically, the polishing pad may have various hardnesses or thicknesses, may be of various types such as a polyurethane type, a nonwoven fabric type, or a suede type, and may or may not include abrasives.

The polishing compositions described above may be used for polishing and then collected to be used for polishing again. As an example method of reusing the polishing composition, a method of collecting, in a tank, a used polishing composition discharged from a polishing apparatus, circulating the collected polishing composition from the tank to the polishing apparatus, and using the polishing composition again, may be used. The use of such a circulated polishing composition can reduce the amount of the polishing composition discharged as a waste liquid so that the amount of the used polishing composition can be reduced. This is effective in terms of reduction of an environmental load and reduction of costs for manufacturing a polishing object.

With the use of the circulated polishing composition, components such as silica in the polishing composition are consumed by polishing and lost. Thus, components corresponding to the reduced components such as silica may be added to the polishing composition being used by circulation. The components to be added may be individually added to the polishing composition, or may be added to the polishing composition as a mixture including two or more components in arbitrary concentrations. In this case, the polishing composition is adjusted to a state suitable for reuse of the polishing composition, and polishing performance is appropriately maintained.

Polishing conditions include a supply rate of the polishing composition. The supply rate of the polishing composition depends on the type of a polishing object, the type of a polishing apparatus, and other polishing conditions, and is preferably a rate sufficient for uniformly supplying the polishing composition to the entire polishing object or polishing pad.

### [Examples]

Examples and comparative examples of the present invention will now be described.

### (Example 1)

Silicas having various particle diameter s and included in amounts indicated in Table 2 were mixed, and the pH was adjusted, thereby preparing polishing compositions of Inventive Examples 1 to 4 of the present invention and Comparative Examples 1 to 3. As a pH adjuster, nitric acid and potassium hydroxide were used. With the polishing compositions of the inventive examples and the comparative examples, three sapphire substrates (a surface) were polished under the following polishing conditions at the same time. Each of the sapphire substrates used had a circular shape having a diameter of 50.8 mm (2 inches). A polishing composition having a total volume of 1000 ml was used for polishing while being circulated at a supply rate of 160 mL/min.

### (Polishing Conditions)

Polishing apparatus: 6B-type double-side polishing apparatus (manufactured by HAMAI CO.,LTD. and having a surface plate diameter of 380 mm)
Polishing pad: nonwoven fabric polishing pad "SUBA800" (manufactured by Nitta Haas Incorporated)
Polishing load: 500 g/cm² (29.4 kPa)
Rotation rate of surface plate: 40 rpm
Supply rate of polishing composition: 160 mL/min

Table 1 indicates an average particle diameter A and a content of small-particle diameter silica having a particle diameter of 20 nm or more to 70 nm or less and an average particle diameter B and a content of large-particle diameter silica having a particle diameter of 100 nm or more to 200 nm or less in each polishing composition, a value (B/A) obtained by dividing the average particle diameter B of the large-particle diameter silica by the average particle diameter A of the small-particle diameter silica, and pH. The average particle diameter of silica was measured with image analysis software. The measurement was performed on 200 pieces of silica (20 pieces of silica per one visual field) in total selected from 10 visual fields of a scanning electron microscope. To calculate a polishing rate of each polishing composition, a mass of each sapphire substrate was measured before and after polishing. The polishing rate calculated from the difference between substrate masss before and after polishing was indicated in the section of "Polishing rate" in Table 1.

**[Table 1]**

| | Inventi ve Example 1 | Inventi ve Example 2 | Inventi ve Example 3 | Inventi ve Example 4 | Compara tive Example 1 | Compara tive Example 2 | Compara tive Example 3 |
|---|---|---|---|---|---|---|---|
| Average particle diameter A (nm) of small-particle diameter silica | 40 | 40 | 50 | 30 | 65 | - | 35 |
| Content (mass%) of small-particle diameter silica | 11 | 22 | 15 | 15 | 15 | 0 | 20 |
| Average particle diameter B (nm) of large-particle diameter silica | 120 | 120 | 110 | 130 | 110 | 110 | - |
| Content (mass%) of large-particle diameter silica | 6 | 12 | 3 | 5 | 5 | 20 | 0 |
| B/A | 3.0 | 3.0 | 2.2 | 4.3 | 1.7 | - | - |
| Silica content (mass%) | 20 | 40 | 20 | 20 | 20 | 20 | 20 |
| pH | 9.7 | 9.5 | 9.5 | 9.5 | 9.7 | 10 | 9 |
| Polishing rate (µm/hour) | 1.2 | 1.1 | 1.0 | 1.1 | 0.8 | 0.3 | 0.6 |

As indicated in Table 1, in the case of polishing sapphire with the polishing compositions of Inventive Examples 1 to 4, high polishing rates were obtained without an increase of a polishing resistance. These polishing performances were achieved with relatively small silica contents . On the other hand, insufficient polishing rates were obtained in Comparative Examples 1 to 3.

### (Example 2)

Abrasives of silica having a particle diameter, a content, and a B/A value indicated in Table 2, water as a liquid medium, and a pH adjuster as an additive were mixed, and the abrasives were dispersed in water, thereby producing polishing compositions of Inventive Example 5 and Comparative Examples 4 and 5. For polishing compositions of Inventive Example 5 and Comparative Examples 4 and 5, nitric acid was used as a pH adjuster.

With the polishing compositions of Inventive Example 5 and Comparative Examples 4 and 5, a rectangular plate member (with dimensions of 60 mm in length and 80 mm in width) of white zirconia ceramic was polished under polishing conditions described below. Then, a mass of the rectangular plate member before polishing and a mass of the rectangular plate member after polishing were measured. From the difference between the mass before polishing and the mass after polishing, a polishing rate was calculated. Table 2 indicates results.

### (Polishing Conditions)

Polishing apparatus: single-side polishing apparatus (surface plate diameter: 380 mm)
Polishing cloth: polyurethane polishing cloth
Polishing load: 285 gf/cm²
Rotation rate of surface plate: 90 min⁻¹
Polishing rate (linear rate): 71.5 m/min
Polishing time: 15 min
Supply rate of polishing composition: 26 mL/min

**[Table 2]**

| | Inventive Example 5 | Comparative Example 4 | Comparative Example 5 |
|---|---|---|---|
| Average particle diameter A (nm) of small-particle diameter silica | 30 | 35 | 35 |
| Content (mass%) of small-particle diameter silica | 15 | 1 | 20 |
| Average particle diameter B (nm) of large-particle diameter silica | 130 | 130 | - |
| Content (mass%) of large-particle diameter silica | 5 | 19 | 0 |
| B/A | 4.3 | 3.7 | - |
| Silica content (mass%) | 20 | 20 | 20 |
| pH | 8.0 | 8.0 | 8.0 |
| Polishing rate (µm/hour) | 0.058 | 0.035 | 0.010 |

As indicated in Table 2, in the case of polishing zirconia with the polishing composition of Inventive Example 5, a polishing rate higher than those of Comparative Examples 4 and 5 was obtained.

### (Example 3)

With the polishing composition of Inventive Example 1, alumina and yttria of sintered bodies (ceramic) were polished under conditions similar to those of Example 1, and a sufficiently high polishing rate similar to that of Inventive Example 1 was obtained for each of alumina and yttria.

## Claims

1. A polishing composition for use in polishing of a surface of a polishing object including at least one of an oxide of a metal or a semimetal or a composite material of oxides of one or more metals and/or semimetals, the polishing composition comprising at least water and silica, wherein
the silica includes small-particle diameter silica having a particle diameter of 20 nm or more to 70 nm or less and large-particle diameter silica having a particle diameter of 100 nm or more to 200 nm or less,
2 mass% or more of the small-particle diameter silica is included in the polishing composition,
2 mass% or more of the large-particle diameter silica is included in the polishing composition, and
a value obtained by dividing an average particle diameter of the large-particle diameter silica by an average particle diameter of the small-particle diameter silica is 2 or more.

2. The polishing composition according to claim 1, wherein a proportion of a sum of the small-particle diameter silica and the large-particle diameter silica in a total amount of the silica is 90 mass% or more.

3. The polishing composition according to claim 1 or 2, wherein 50 mass% or more of the small-particle diameter silica is included in the total amount of the silica.

4. The polishing composition according to any one of claims 1 to 3, wherein a content of each of the small-particle diameter silica and the large-particle diameter silica is 4 mass% or more.

5. The polishing composition according to any one of claims 1 to 4, wherein the polishing composition has a pH of 7.5 or more to 9.8 or less.

6. The polishing composition according to any one of claims 1 to 5, wherein the polishing object includes at least one of an oxide of one or more metals or semimetals selected from Groups 3, 4, and 13 or a composite material of oxides of one or more metals and/or semimetals selected from Groups 3, 4, and 13.

7. A polishing method for polishing a hard brittle substrate, wherein the hard brittle substrate is polished by using the polishing composition according to any one of claims 1 to 6.

8. A method for manufacturing a hard brittle substrate, the method comprising the step of polishing a hard brittle substrate by using the polishing method according to claim 7.
